# EUROPEAN PATENT SPECIFICATION

(11) **EP 2 176 195 B1**
(45) Date of publication and mention of the grant of the patent: **21.09.2011**
(21) Application number: 08770771.7
(22) Date of filing: 12.06.2008
(51) Int. Cl.: C04B 41/91, G02B 1/00

(54) **TREATMENT METHOD FOR OPTICALLY TRANSMISSIVE BODY**
BEHANDLUNGSVERFAHREN FÜR OPTISCH DURCHLÄSSIGEN KÖRPER
PROCEDE DE TRAITEMENT D'UN CORPS OPTIQUEMENT TRANSMISSIF

(30) Priority: 29.06.2007 US 771181
(43) Date of publication of application: 21.04.2010
(73) Proprietor: Raytheon Company, Waltham, MA 02451 (US)
(72) Inventor: HOGAN, Patrick K., Wilmington, NC 28412 (US); KORENSTEIN, Ralph, Framingham, Massachusetts 01702 (US); MCCLOY, John S., Tucson, Arizona 85730 (US)
(74) Representative: Jackson, Richard Eric
(86) International application number: PCT/US2008/066633
(87) International publication number: WO 2009/005988

(56) References cited:
- US-A- 4 944 900
- US-A- 5 281 465

## Description

### BACKGROUND OF THE INVENTION

### TECHNICAL FIELD OF THE INVENTION

This invention relates generally to optical elements and methods for treating optical elements.

### DESCRIPTION OF THE RELATED ART

As it is known in the art, some optical imaging systems include one or more externally mounted optical elements that shield the remainder of the imaging system from an external environment. For example, with infrared airborne imaging systems, an IR transparent optical element, such as a window or dome, may be part of the airborne system, used to isolate the remainder of the imaging system from exposure to humid, corrosive, and abrasive environments. Such elements often find applications on missiles, for example as part of a radar dome for a missile.

Zinc sulfide and zinc selenide have been used in the past as a material for such domes. These materials are capable of providing a degree of mechanical durability and of providing reasonable optical performance in the long infrared imaging wavelength band of approximately 8-12 microns.

Chemically-vapor-deposited zinc sulfide or zinc selenide has been treated in order to improve optical properties of the material for visible and near-infrared wavelengths, for example by changing the chemically-vapor-deposited zinc sulfide to multispectral zinc sulfide. One way of doing so has been to bring platinum into contact with the zinc sulfide or zinc selenide, and then heat the combination under pressure in a hot isostatic pressure (HIP) treatment. Such a treatment is described in U.S. Patent No. 4,944,900.

However platinum is an expensive material, and its use increases the cost of the treatment. There is thus room for improvement with regard to such optical materials and their treatment.

### SUMMARY OF THE INVENTION

According to an aspect of the invention a process for improving optical characteristics of a transmissive material includes placing a non-platinum metal layer on at least one surface of the transmissive material, and subjecting the transmissive material and layer to elevated temperature and elevated pressure.

According to another aspect of the invention a method of treating a transmissive body of zinc sulfide or zinc selenide includes the steps of: placing a non-platinum metal layer on a surface of the transmissive body; and improving optical properties of the transmissive body by heating the metal layer and the transmissive body. The heating is performed at an elevated temperature above normal ambient temperature and at an elevated pressure above normal ambient pressure.

To the accomplishment of the foregoing and related ends, the invention comprises the features hereinafter fully described and particularly pointed out in the claims. The following description and the annexed drawings set forth in detail certain illustrative embodiments of the invention. These embodiments are indicative, however, of but a few of the various ways in which the principles of the invention may be employed. Other objects, advantages and novel features of the invention will become apparent from the following detailed description of the invention when considered in conjunction with the drawings.

### BRIEF DESCRIPTION OF THE DRAWINGS

In the annexed drawings, which are not necessarily to scale:

Fig. 1 is a cross-sectional view of an optical device of transmissive material, prior to treatment;

Fig. 2 is a cross-sectional view of the transmissive body of Fig. 1, with a non-platinum metal layer on a surface of the body, in accordance with an embodiment of the invention;

Fig. 3 is a detailed view of portions of the body and the layer of Fig. 2;

Fig. 4 is a view of the same portion as Fig. 3, illustrating changes in a hot isostatic pressure (HIP) process to improve optical characteristics of the transmissive body; and

Fig. 5 is a cross-sectional view of the transmissive body after removal of the non-platinum material layer.

### DETAILED DESCRIPTION

A method of treating a transmissive body of zinc sulfide or zinc selenide includes placing a non-platinum metal layer, such as a layer of cobalt, silver, or iron, on a surface of the transmissive body, and improving the optical properties of the transmissive body by subjecting the body and the layer to an elevated temperature and elevated pressure. The zinc sulfide or zinc selenide may be chemical vapor deposited material. The non-platinum metal of the non-platinum metal layer is a non-platinum metal selected to advantageously affect the optical properties of the transmissive material in a subsequent heating at elevated pressure. In particular, the reduction of free sulfur or free selenium (or other species) in the transmissive body portion may improve optical properties for visible and near infrared (NIR) wavelengths. Of particular interest may be wavelengths of about 1064 nm or 1 micron, which are wavelengths that are utilized by semi-active laser (SAL) seekers. Transmission at this wavelength as been found to closely correlate with transmission throughout the visible and NIR wavelengths. The non-platinum metal may be selected for characteristics desirable in a hypothesized mechanism that is believed to be responsible for the improvement of optical properties of the transmissive material. This hypothesized mechanism has been found useful in selecting non-platinum metal materials that have been found to be effective in improving optical properties in the transmissive material. However, it will be appreciated that the mechanism is to some degree speculative, and that other mechanisms may be responsible for the advantageous results of the method described herein. The non-platinum metal of the layer may be such that a Gibbs free energy of formation of a most stable sulfide (or selenide) of the non-platinum metal is more negative than a Gibbs free energy of formation of a most stable zinc sulfide (or zinc selenide) configuration that is thermodynamically capable of reacting with the non-platinum metal. With this condition the non-platinum metal preferentially chemically bonds with free sulfur (or free selenium) in preference to zinc sulfide (or zinc selenium). The non-platinum metal layer may be in the form of a foil that is brought into contact with a surface of the transmissive body. Alternatively the non-platinum metal layer may be sputtered or evaporated onto the surface of the transmissive body. After the non-platinum metal layer is placed into contact with the transmissive body surface, the optical characteristics of the transmissive body may be improved by heating the transmissive body and the non-platinum metal layer to an elevated temperature (above ambient temperature), at an elevated pressure (above ambient pressure). The heating may at least maintain the strength of the transmissive body, and may improve the strength of the transmissive body. It is believed that the improved properties of the transmissive body occur by diffusion of free sulfur (or free selenium) into the non-platinum metal layer, where the free sulfur (or free selenium) chemically bonds with the non-platinum metal. Reduction of the free sulfur (or free selenium) in the zinc sulfide (or zinc selenide) improves optical properties, and may also improve strength. In particular, the reduction of free sulfur or free selenium may improve optical properties for visible and near infrared (NIR) wavelengths. Of particular interest may be wavelengths of about 1064 nm or 1 micron, which are wavelengths that are utilized by semi-active laser (SAL) seekers. Transmission at this wavelength as been found to closely correlate with transmission throughout the visible and NIR wavelengths. In addition some of the non-platinum metal may diffuse into the transmissive body. After the heating the non-platinum metal layer is removed. The removal includes removal of any free sulfur or free selenium that has diffused into the non-platinum metal layer.

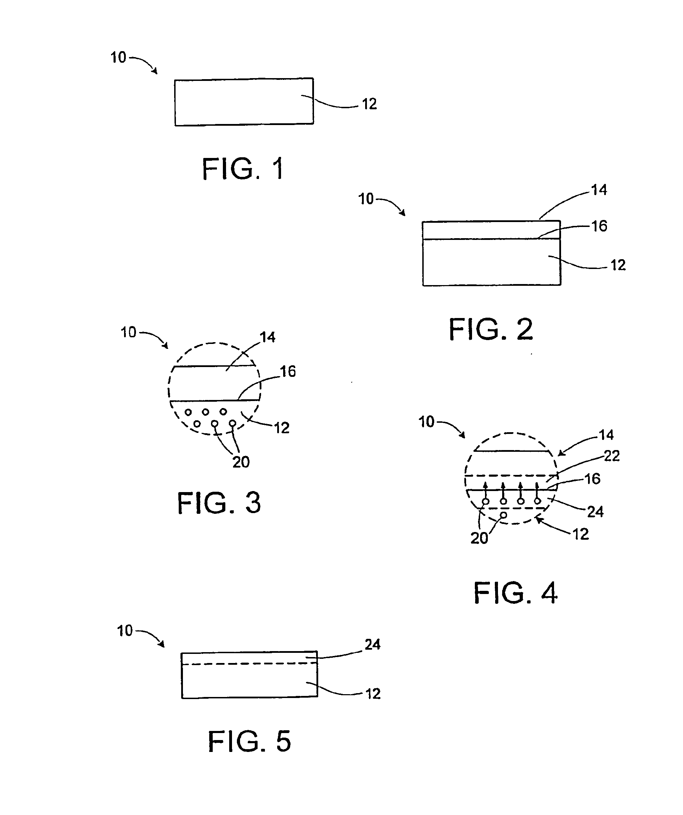

Referring now to Fig. 1, an optical device 10 or an optical element includes a transmissive body portion 12 that includes an optical material that theoretically has transparency in the infrared and visible portions of the electromagnetic spectrum. The transmissive body portion 12 includes zinc sulfide or zinc selenide. It will be appreciated that the transmissive body portion 12 may in addition contain a broader range of materials such as cadmium sulfide, cadmium selenide, cadmium telluride, mercury cadmium telluride, or other chalcoginide materials. The material of the transmissive body portion 12 may be a chemically-vapor-deposited material, formed by a well-known chemical vapor deposition process.

Fig. 2 shows the transmissive body portion 12 with a non-platinum metal layer 14 placed on and/or in contact with a surface 16 of the transmissive body portion 12. Although the non-platinum metal layer 14 is shown only on one side of the body portion 12, it will be appreciated that the non-platinum metal layer 14 will in general be placed on both sides (major surfaces) of the body portion 12. The non-platinum metal layer 14 may be a foil. The foil may have a thickness on the order of 0.03 mm, although it will be appreciated that other thicknesses may be used. Foil of the non-platinum metal may be held against the transmissive body surface, for example by use of weights to press the foil against the surface 16.

Alternatively the non-platinum metal layer 14 may be sputtered onto the surface 16. The sputtered non-platinum metal may have a thickness on the order of 1000 Angstroms, although it will be appreciated that other thicknesses may be used.

The non-platinum metal of the non-platinum metal layer 14 is a non-platinum metal selected to advantageously affect the optical properties of the transmissive material in a subsequent heating at elevated pressure. In particular, the reduction of free sulfur or free selenium in the transmissive body portion 12 may improve optical properties for visible and near infrared (NIR) wavelengths. Of particular interest may be wavelengths of about 1064 nm or 1 micron, which are wavelengths that are utilized by semi-active laser (SAL) seekers. Transmission at this wavelength as been found to closely correlate with transmission throughout the visible and NIR wavelengths. The non-platinum metal may be selected for characteristics desirable in a hypothesized mechanism that is believed to be responsible for the improvement of optical properties of the transmissive material 12. This hypothesized mechanism has been found useful in selecting non-platinum metal materials that have been found to be effective in improving optical properties in the transmissive material 12. However, it will be appreciated that the mechanism is to some degree speculative, and that other mechanisms may be responsible for the advantageous results of the method described herein. In addition, while it is believed that the improved optical properties result from a reduction in free sulfur or free selenium, it will be appreciated that this to some degree speculative, and that improved optical properties may result from alternative or additional mechanisms.

With reference now to Figs. 3 and 4, the mechanism is explained for a transmissive material portion 12 made of zinc sulfide, having an amount of free sulfur 20 within the zinc sulfide. Upon heating under pressure some of the free sulfur 20 diffuses out of the zinc sulfide transmissive body 12 and into the non-platinum metal layer 14, as is illustrated in Fig. 4. In the layer 14 the free sulfur 20 chemically bonds with the non-platinum metal of the layer 14. This chemical bonding may occur at the surface 16, which is the interface between the transmissive material 12 and the non-platinum metal layer 14. The chemical bonding between the free sulfur and the non-platinum metal may produce a non-platinum-metal sulfide region 22 in the layer 14.
It is the removal of some of the free sulfur 20 from the zinc sulfide transmissive material portion 12 that is believed to provide the principal mechanism for improving the optical properties of the zinc sulfide transmissive material.

In addition there may be a region 24 in the transmissive material portion 12 into which the non-platinum metal diffuses. This diffusion of non-platinum metal into the region 24 is believed to provide at best a secondary mechanism for improving characteristics of the transmissive material. It may be possible to substantially fully avoid formation of the region 24, keeping the non-platinum metal from diffusing into the transmissive material 12.

Consistent with the above hypothesized mechanism, it would be desired for the non-platinum metal to easily chemical bond with free sulfur. In addition the non-platinum metal should bond with the sulfur in preference to bonding with the zinc sulfide transmissive material. A non-platinum metal having these two characteristics at the process temperature will sequester the free sulfur, removing it from the zinc sulfide transmissive material, without breaking down the zinc sulfide.

Thermodynamically the first of the above conditions is expressed as a negative Gibbs free energy change for the reaction of the non-platinum metal and sulfur to form a non-platinum-metal sulfide. The second condition is expressed as this Gibbs free energy of formation not being more negative than the Gibbs free energy of formation for a hypothetical reaction between the non-platinum metal and the most stable zinc sulfide form, at the elevated temperature at which process is performed. The relevant Gibbs free energies of formation for this comparison are the Gibbs free energies of formation at the elevated temperature at which the optical improvement process is to be carried out.

In addition to the Gibbs free energy criteria, it is desirable or required that the non-platinum metal have a high melting temperature (certainly higher than the treatment temperature), a relatively low vapor pressure such that there is no appreciable material loss during heat treatment, and a low cost. From these criteria cobalt, silver, and iron were identified as good candidates for the non-platinum metal.

The above description is in terms of selection of a non-platinum metal to remove free sulfur from zinc sulfide. It will be appreciated that an analogous selection process may be made to selecting a non-platinum metal to remove free selenium from zinc selenide. The analogous selection process may be based on comparing analogous Gibbs free energies, and by using the other selection criteria described above. Other analogous selection processes may be envisioned for removing unwanted materials from other transmissive body materials.

The process illustrated in Figs. 3 and 4 is performed at an elevated pressure and an elevated temperature. The process may be a hot isostatic pressure (HIP) process that involves simultaneous application of heat and pressure through use of an inert working fluid. An elevated pressure of 2·1x10⁸ pascals (30,000 psi) is suitable for the HIP process, although it will be appreciated that other suitable elevated pressures may be used. A broad range of pressure may be employed, such as from 1·4x10⁷ to 5·5x10⁸ pascals (2,000 to 80,000 psi).
Performing the process at an elevated pressure improves consistency of the results. The elevated pressure may reduce porosity of materials, although there may be different or additional mechanisms affected by the elevated pressure.

The optical characteristics of the resulting transmissive material were found to vary significantly with the type of non-platinum metal used, and with the temperature of the HIP process. In addition, the type of non-platinum metal layer (foil or sputtered) affected results. It is believed that for foils chemical bonding between the non-platinum metal and the free sulfur (or free selenium) occurs when the free sulfur (or free selenium) first goes into the gas phase, and only then enters the non-platinum metal. Foils provide a small gap between the transmissive material 12 and the non-platinum metal layer 14. This gap forces the free sulfur 20 to first pass through the intervening gas before entering the non-platinum metal layer 14.

Sputtered layers do not provide a gap between the transmissive material 12 and the non-platinum metal layer 14. For sputtered layers there is a more direct diffusion of free sulfur (or selenium) from the transmissive material 12 and the non-platinum metal layer 14. With this more direct mechanism sputtered materials were found to achieve good optical properties at lower temperature HIP processes than those required for foil material layers. However, the gapless direct contact between the sputter non-platinum material layer 14 and the transmissive body 12 may result in greater diffusion of non-platinum material into the transmissive body material. The diffusion of non-platinum material into the transmissive body material may degrade optical properties of the transmissive material, particularly at shorter wavelengths, such as 700 nm. Thus foil material may more advantageous in certain circumstances, such as where relatively short wavelength transmissivity is required.

Zinc sulfide optical property improvement for HIP processes with cobalt foil was found at temperatures of 900 degrees C, 950 degrees C, 990 degrees C, and 1025 degrees C. Of these samples the best result was for a HIP process run at 950 degrees C for 12 hours. This sample had an attenuation coefficient of 0.12 cm⁻¹ for radiation with a 1064 nm wavelength.

Sputtered cobalt for the non-platinum metal layer 14 was also found to produce good optical property improvements in chemical-vapor-deposited zinc sulfide. For a HIP treatment run at 990 degrees C for three hours, the resulting attenuation coefficient at 1064 nm was found to be 0.14 cm⁻¹. For a HIP treatment run at 850 degrees C for twelve hours, the resulting attenuation coefficient at 1064 nm was found to be 0.18 cm⁻¹. However, HIP temperatures below 850 degrees C resulted in higher attenuation coefficients.

Silver foil was also found to be very effective in improving optical properties (reducing attenuation coefficient). An attenuation coefficient (for 1064 nm radiation) of 0.13 cm⁻¹ was found for a sample HIP processed at 750 degrees C for 16 hours. Results were worse for samples HIP processed at the same temperature for shorter times (3 hours and 12 hours). Longer times (72 hr) resulted in an attenuation coefficient of 0.06 cm⁻¹.

Iron foil was also found to be effective in improving optical properties (reducing attenuation coefficient). An attenuation coefficient (for 1064 nm radiation) of 0.12 cm⁻¹ was found for a sample HIP processed at 950 degrees C for 16 hours. A similar attenuation coefficient of 0.13 cm⁻¹ was found for a sample HIP processed at 900 degrees C for 32 hours.

More broadly, a suitable temperature range for the methods described herein is 700 to 1050 degrees C. Similar temperatures may be used in processes on both zinc sulfide and zinc selenide.

The methods described herein advantageously improve the visible and NIR (near infrared) optical properties while providing a resulting material with better strength than that of prior art platinum-utilizing processes. Prior art platinum-utilizing processes may reduce strength by about 50% in the course of forming multispectral ZnS. It is believed that a smaller strength reduction may result from the present non-platinum methods, such that multispectral zinc sulfide made by the non-platinum processes described herein may have greater strength than multispectral zinc sulfide made by platinum processes.

Turning now to Fig. 5, the layer 14 is removed after the HIP process is completed. Any compounds that are part of the layer 14 are removed along with the rest of the layer. The transmissive material 12 may then be treated further, for example by polishing.

Although the invention has been shown and described with respect to a certain preferred embodiment or embodiments, it is obvious that equivalent alterations and modifications will occur to others skilled in the art upon the reading and understanding of this specification and the annexed drawings. In particular regard to the various functions performed by the above described elements (components, assemblies, devices, compositions, etc.), the terms (including a reference to a "means") used to describe such elements are intended to correspond, unless otherwise indicated, to any element within the scope of the claims which performs the specified function of the described element (i.e., that is functionally equivalent), even though not structurally equivalent to the disclosed structure which performs the function in the herein illustrated exemplary embodiment or embodiments of the invention. In addition, while a particular feature of the invention may have been described above with respect to only one or more of several illustrated embodiments, such feature may be combined with one or more other features of the other embodiments, as may be desired and advantageous for any given or particular application within the scope of the claims.

## Claims

1. A method of treating a transmissive body (12) of zinc sulfide or zinc selenide, the method comprising:
placing a non-platinum metal layer (14) on at least one surface of the transmissive body; and
improving optical properties of the transmissive body by heating the metal layer and the transmissive body, wherein the heating is performed at an elevated temperature above normal ambient temperature and at an elevated pressure above normal ambient pressure; and
after the heating, removing the layer;
wherein the non-platinum metal layer includes silver.

2. The method of claim 1, wherein the transmissive body includes zinc sulfide.

3. The method of claim 2,
wherein the heating includes removing free sulfur from the zinc sulfide; and wherein the removing the free sulfur includes chemically bonding the free sulfur and the non-platinum metal.

4. The method of claim 3, wherein the removing the layer includes removing at least some of the non-platinum metal and the free sulfur chemically bonded during the chemically bonding.

5. The method of claim 3 or claim 4, wherein the chemically bonding includes chemically bonding at least in part within the non-platinum metal layer.

6. The method of claim 3 or claim 4, wherein the chemically bonding includes chemically bonding at least in part at an interface between the transmissive body and the non-platinum metal layer.

7. The method of any of claims 1 to 6, wherein the elevated temperature is a temperature from 700 degrees C to 1050 degrees C.

8. The method of any of claims 1 to 7, wherein the elevated pressure is a pressure from 1.4 × 10⁷ Pa to 5.5 × 10⁸ Pa (2,000 to 80,000 psi).

9. The method of any of claims 1 to 8, wherein the transmissive body is formed by chemical vapor deposition.

10. The method of any of claims 1 to 8, wherein the layer is a foil.

11. The method of any of claims 1 to 9, wherein the placing the layer includes sputtering the non-platinum metal layer onto the at least one surface of the transmissive body.

## Patentansprüche

1. Verfahren zum Behandeln eines durchlässigen Körpers (12) aus Zinksulfid oder Zinkselenid, wobei das Verfahren Folgendes umfasst:
Anordnen einer nicht aus Platin bestehenden Metallschicht (14) auf mindestens einer Fläche des durchlässigen Körpers; und
Verbessern der optischen Eigenschaften des durchlässigen Körpers durch Erwärmen der Metallschicht und des durchlässigen Körpers, wobei das Erwärmen bei einer erhöhten Temperatur oberhalb der normalen Umgebungstemperatur und bei einem erhöhten Druck oberhalb des normalen Umgebungsdrucks ausgeführt wird; und
Entfernen der Schicht nach dem Erwärmen;
wobei die nicht aus Platin bestehende Metallschicht Silber enthält.

2. Verfahren nach Anspruch 1, wobei der durchlässige Körper Zinksulfid enthält.

3. Verfahren nach Anspruch 2,
wobei das Erwärmen das Entfernen von freiem Schwefel aus dem Zinksulfid enthält; und
wobei das Entfernen des freien Schwefels das chemische Binden des freien Schwefels und des Nichtplatinmetalls enthält.

4. Verfahren nach Anspruch 3, wobei das Entfernen der Schicht das Entfernen mindestens eines Teils des Nichtplatinmetalls und des freien Schwefels, der während des chemischen Bindens chemisch gebunden wurde, enthält.

5. Verfahren nach Anspruch 3 oder Anspruch 4, wobei das chemische Binden das chemische Binden mindestens zum Teil innerhalb der nicht aus Platin bestehenden Metallschicht enthält.

6. Verfahren nach Anspruch 3 oder Anspruch 4, wobei das chemische Binden das chemische Binden mindestens zum Teil an einer Grenzfläche zwischen dem durchlässigen Körper und der nicht aus Platin bestehenden Metallschicht enthält.

7. Verfahren nach einem der Ansprüche 1 bis 6, wobei die erhöhte Temperatur eine Temperatur von 700°C bis 1050°C ist.

8. Verfahren nach einem der Ansprüche 1 bis 7, wobei der erhöhte Druck ein Druck von 1,4 × 10⁷ Pa bis 5,5 × 10⁸ Pa (2.000 bis 80.000 psi) ist.

9. Verfahren nach einem der Ansprüche 1 bis 8, wobei der durchlässige Körper durch chemisches Aufdampfen gebildet wird.

10. Verfahren nach einem der Ansprüche 1 bis 8, wobei die Schicht eine Folie ist.

11. Verfahren nach einem der Ansprüche 1 bis 9, wobei das Anordnen der Schicht das Sputtern der nicht aus Platin bestehenden Metallschicht auf die mindestens eine Fläche des durchlässigen Körpers enthält.

## Revendications

1. Procédé de traitement d'un corps transmissif (12) en sulfure de zinc ou en séléniure de zinc, le procédé comprenant :
la mise en place d'une couche métallique sans platine (14) sur au moins une surface du corps transmissif ; et
l'amélioration des propriétés optiques du corps transmissif par chauffage de la couche métallique et du corps transmissif, le chauffage étant effectué à une température élevée, au-dessus de la température ambiante normale, et à une pression élevée, au-dessus de la pression ambiante normale ; et
après le chauffage, retrait de la couche ;
dans lequel la couche métallique sans platine comprend de l'argent.

2. Procédé selon la revendication 1, dans lequel le corps transmissif comprend du sulfure de zinc.

3. Procédé selon la revendication 2,
dans lequel le chauffage comprend le retrait de soufre libre du sulfure de zinc ; et
dans lequel le retrait du soufre libre comprend la liaison chimique du soufre libre et du métal différent du platine.

4. Procédé selon la revendication 3, dans lequel le retrait de la couche comprend le retrait d'au moins une partie du métal différent du platine et du soufre libre liés chimiquement au cours de la liaison chimique.

5. Procédé selon la revendication 3 ou la revendication 4, dans lequel la liaison chimique comprend une liaison chimique au moins en partie à l'intérieur de la couche métallique sans platine.

6. Procédé selon la revendication 3 ou la revendication 4, dans lequel la liaison chimique comprend une liaison chimique au moins en partie à une interface entre le corps transmissif et la couche métallique sans platine.

7. Procédé selon l'une quelconque des revendications 1 à 6, dans lequel la température élevée est une température de 700 degrés C à 1050 degrés C.

8. Procédé selon l'une quelconque des revendications 1 à 7, dans lequel la pression élevée est une pression de 1,4.10⁷ Pa à 5,5. 10⁸ Pa (2000 à 80 000 psi).

9. Procédé selon l'une quelconque des revendications 1 à 8, dans lequel le corps transmissif est formé par dépôt chimique en phase vapeur.

10. Procédé selon l'une quelconque des revendications 1 à 8, dans lequel la couche est une feuille.

11. Procédé selon l'une quelconque des revendications 1 à 9, dans lequel la mise en place de la couche comprend la pulvérisation cathodique de la couche métallique sans platine sur l'au moins une surface du corps transmissif.
